# EUROPEAN PATENT APPLICATION

(11) **EP 4 354 498 A1**
(43) Date of publication of application: **17.04.2024**
(21) Application number: 23198071.5
(22) Date of filing: 18.09.2023
(51) Int. Cl.: H01L 23/495, H01L 23/498

(54) **ISOLATED POWER PACKAGING WITH FLEXIBLE CONNECTIVITY**

(30) Priority: 29.09.2022 US 202217955877
(71) Applicant: Littelfuse, Inc., Chicago, IL 60631 (US)
(72) Inventor: Hughes, Rhodri, Chicago, 60631 (US)
(74) Representative: Arnold & Siedsma

(57) **Abstract**

An isolated packaging structure and methods thereof. The structure includes a housing having a top side and a bottom side. The housing encapsulates one or more electronic components. The structure also include one or more openings disposed in the bottom side of the housing. One or more openings are configured for exposing one or more metallized surfaces of one or more electronic components. One or more metallized surfaces are configured for coupling to one or more lead terminals.

## Description

### TECHNICAL FIELD

This disclosure relates generally to the field of semiconductor packaging, and in particular, to power substrate packaging, such as, for example, an over-molded isolated substrate packaging.

### BACKGROUND

Packaging an integrated circuit is typically a final stage of a semiconductor device fabrication process. During packaging, a semiconductor die, which represents the core of a semiconductor device, is encased in a housing that protects the die against physical damage and corrosion. For example, semiconductor dies are commonly mounted on a copper substrate, using solder alloy reflow, conductive epoxy, etc. The mounted semiconductor die is often then encapsulated within a plastic or epoxy compound.

Substrates for power electronics are different than printed circuit boards used for low power microelectronics. The power electronics substrate both provides the interconnections to form an electrical circuit and cool the components. Power electronic substrates carry higher currents and provide a higher voltage isolation (up to several thousand volts), as compared to microelectronic counterparts, and operate over a wide temperature range.

However, existing packaging technologies do not provide sufficient flexibility for creating a variety of lead connections. Moreover, conventional systems suffer from voltage creepage (due to the distance between leads).

### SUMMARY

The following summary is provided to introduce a selection of concepts in a simplified form that are further described below in the detailed description. This summary is not intended to identify key or essential features of the claimed subject matter, nor is it intended as an aid in determining the scope of the claimed subject matter.

In some implementations, the current subject matter relates to an isolated substrate packaging system, device, apparatus, and any associated methods thereof. The apparatus may include a housing having a top side and a bottom side. The housing may encapsulate one or more electronic components. The apparatus may also include one or more openings disposed in the bottom side of the housing. The openings may be configured for exposing one or more metallized surfaces of one or more electronic components. The metallized surfaces may be configured for coupling to one or more lead terminals.

In some implementations, the current subject matter may include one or more of the following optional features. One or more electronic components may include at least one of the following: direct copper bonded (DCB) substrate components, active metal brazed (AMB) substrate components, insulated metal substrate (IMS) components, and any combination thereof.

In some implementations, the housing may be configured encapsulate one or more semiconductor chips coupled to the one or more electronic components. One or more semiconductor chips and one or more electronic components may be configured to be coupled using at least one of the following: wire-bonding, one or more electrically-conductive clips, silver-sintering, soldering, and any combination thereof.

In some implementations, one or more lead terminals may be configured to be coupled to one or more metallized surfaces of one or more electronic components by inserting one or more lead terminals through one or more openings, contacting inserted one or more lead terminals with one or more metallized surfaces, and coupling one or more contacting lead terminals and one or more metallized surfaces. One or more lead terminals may be permanently coupled to one or more metallized surfaces. The apparatus may be configured for at least one of through-hole mounting and surface mounting to at least another one or more electronic components using one or more permanently coupled lead terminals.

In some implementations, one or more lead terminals may be temporarily coupled to one or more metallized surfaces. The apparatus may be configured for push-fit mounting to at least another one or more electronic components using one or more temporarily coupled lead terminals.

In some implementations, one or more lead terminals may be manufactured using at least one of the following: a copper, a copper alloy, a metal, a metal alloy, and any combination thereof.

In some implementations, the housing may be manufactured from at least one of the following: an epoxy compound, a plastic, and any combination thereof.

In some implementations, the current subject matter relates to a packaging structure, which may include a housing having a top side and a bottom side. The housing may encapsulate one or more electronic components. The structure may include one or more openings disposed in the bottom side of the housing. The openings may be configured for exposing one or more metallized surfaces of one or more electronic components. The structure may also include one or more lead terminals. The metallized surfaces may be configured for coupling to one or more lead terminals. One or more lead terminals may be configured to be coupled to one or more metallized surfaces of one or more electronic components by inserting one or more lead terminals through one or more openings, contacting inserted one or more lead terminals with one or more metallized surfaces, and coupling contacting one or more lead terminals and one or more metallized surfaces.

In some implementations, the current subject matter's packaging structure may include one or more of the following optional features. One or more electronic components may include at least one of the following: direct copper bonded (DCB) substrate components, active metal brazed (AMB) substrate components, insulated metal substrate (IMS) components, and any combination thereof. The housing may be configured encapsulate one or more semiconductor chips coupled to one or more electronic components. One or more semiconductor chips and one or more electronic components may be configured to be coupled using at least one of the following: wire-bonding, one or more electrically-conductive clips, silver-sintering, soldering, and any combination thereof.

In some implementations, one or more lead terminals may be permanently coupled to one or more metallized surfaces. The structure may be configured for at least one of through-hole mounting and surface mounting to at least another one or more electronic components using one or more permanently coupled lead terminals.

In some implementations, one or more lead terminals may be temporarily coupled to one or more metallized surfaces. The structure may be configured for push-fit mounting to at least another one or more electronic components using one or more temporarily coupled lead terminals.

In some implementations, one or more lead terminals may be manufactured using at least one of the following: a copper, a copper alloy, a metal, a metal alloy, and any combination thereof.

In some implementations, the housing may be manufactured from at least one of the following: an epoxy compound, a plastic, and any combination thereof.

The details of one or more variations of the subject matter described herein are set forth in the accompanying drawings and the description below. Other features and advantages of the subject matter described herein will be apparent from the description and drawings, and from the claims.

### BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosed implementations. In the drawings,
FIGS. 1a-f illustrates an exemplary packaging structure, according to some implementations of the current subject matter;
FIG. 2 illustrates exemplary packaging structures, according to some implementations of the current subject matter;
FIG. 3 illustrates another exemplary packaging structure, according to some implementations of the current subject matter; and
FIG. 4 illustrates yet another exemplary packaging structure, according to some implementations of the current subject matter.

The drawings are not necessarily to scale. The drawings are merely representations, not intended to portray specific parameters of the disclosure. The drawings are intended to depict exemplary implementations of the current subject matter, and therefore, are not to be considered as limiting in scope. In the drawings, like numbering represents like elements.

Further, certain elements in some of the figures may be omitted, and/or illustrated not-to-scale, for illustrative clarity. Cross-sectional views may be in the form of "slices", and/or "near-sighted" cross-sectional views, omitting certain background lines otherwise visible in a "true" cross-sectional view, for illustrative clarity. Additionally, for clarity, some reference numbers may be omitted in certain drawings.

### DETAILED DESCRIPTION

Various approaches in accordance with the present disclosure will now be described more fully hereinafter with reference to the accompanying drawings, where implementations of a system and method are shown. The devices, system(s), component(s), etc., may be embodied in many different forms and are not to be construed as being limited to the example implementations set forth herein. Instead, these example implementations are provided so this disclosure will be thorough and complete, and will fully convey the scope of the current subject matter to those skilled in the art.

To address these and potentially other deficiencies of currently available solutions, one or more implementations of the current subject matter relate to methods, systems, articles of manufacture, and the like that can, among other possible advantages, provide a packaging structure configured for direct access to surface connection of its internal components.

Direct bonded copper (DBC), also known as direct copper bonded (DCB) substrates, have very good thermal conductivity, and are thus suitable for power modules. DCBs are composed of a ceramic tile with a sheet of copper bonded to one or both sides of the ceramic tile. Suitable for smaller lots, active metal brazed (AMB) substrates involve the attachment of thick metal layers to ceramic plates. Insulated metal substrates (IMS) are also used for power modules and consist of a metal baseplate covered by a thin layer of dielectric and a layer of copper. IMS are single-sided substrates.

Some existing packaging technologies include the surface mount power device (SMPD) packaging. Compared to other copper-based lead-frame packages, devices, packaged using SMPD, exhibit better thermal performance, lower weight, and better power cycling capability. The SMPD package can be easily surface-mounted on a printed circuit board (PCB) using a standard pick-and-place and reflow soldering process. No screws, cables, bus-bars or hand soldered contacts are needed. Weighing only 8g, it is much lighter (typically by 50%) than comparable conventional power modules. Further, the SMPD devices have a compact and ultra-low-profile package, thereby allowing use of the same heat sink for multiple devices, saving PCB space. Another added benefit of being smaller and lighter is that it provides a better protection against vibrations and g-forces, especially if used in portable appliances, increasing the life expectancy and reliability of these devices. Surface-mountable high-voltage power MOSFETs and IGBTs may be packaged using this technology. A ceramic isolation of up to 4.5kV is achieved with the DCB substrate technology, where an electrically isolated tab is provided for heat sinking. The DCB provides low thermal impedance and increased power and temperature cycling capabilities.

In some implementations, the current subject matter relates to an over-molded isolated substrate packaging device, such, as for example, a DCB, an AMB and/or other device packaging that may be integrated into a package and may allow direct access to one or more surface connections of internal components (e.g., MOSFET(s), IGBT(s), overvoltage semiconductor(s), passive component(s), control circuit(s), etc.). The packaging device may be manufactured using one or more known insert molding technologies (such, as for example, film-assist molding technologies). The resulting mold may include projections that may contact substrates' metallized surface during encapsulation process leaving open access to one or more terminal points of the substrate surface.

In some implementations, a conductive joint and/or contact may be created directly between the exposed surface terminal. This may allow the packaging device to be configured for multiple end user applications, such as for example, but not limited to, surface mounting, through hole, pressure contact or press-fit contact (e.g., direct contact of DCB terminal with application), and/or any other applications. The exposed "topside" of the isolated substrate may further allow for thermal management. Any internal connections within the packaging device may be made using wire-bonding, electrically-conductive clips, and/or any other suitable methods (e.g., silver (Ag) sinter, solder, etc.). Further, in some exemplary implementations, any terminal configurations may be adjusted to suit various applications through tooling, process, design, etc.

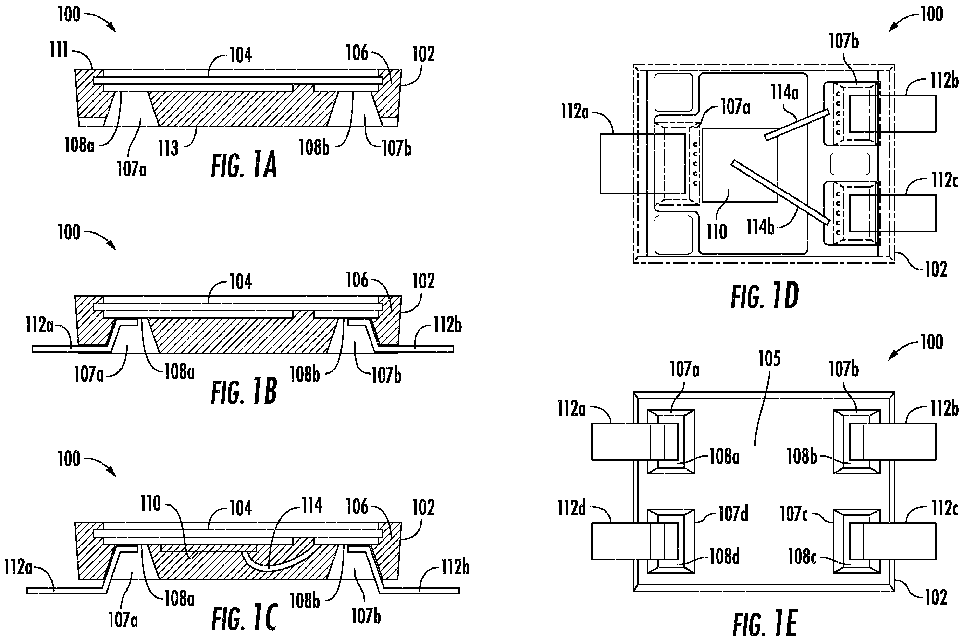

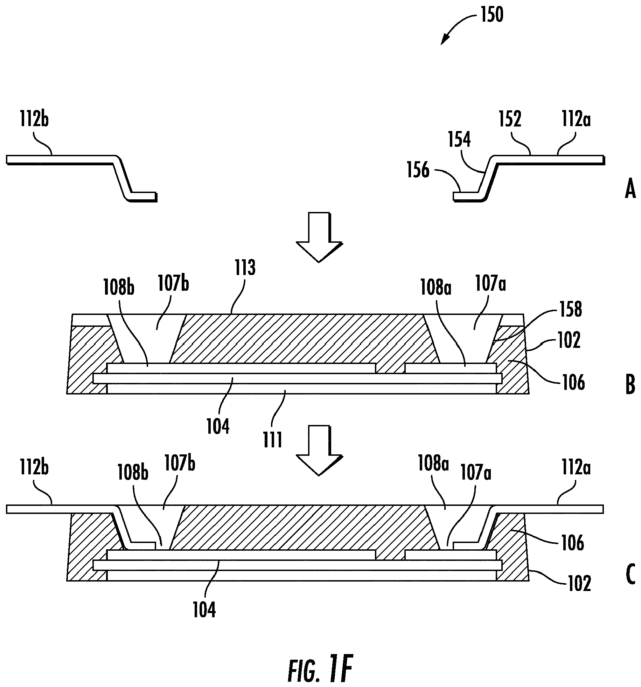

FIGS. 1a-f illustrates an exemplary packaging structure 100, according to some implementations of the current subject matter. FIGS. 1a-c are side views of the structure 100. FIG. 1d is a bottom view of the structure 100 having three openings configured for connections of lead terminals. FIG. 1e is a bottom view of the structure 100 having four openings configured for connections of lead terminals. As can be understood, the structure 100 may include any desired number of openings. FIG. 1f is a side view of the structure 100 illustrating connections of lead terminals.

The structure 100 may be configured to include a housing 102 having a top side 111 and bottom side 113. The housing 102 may encapsulate and/or enclose one or more direct copper bound (DCB) component(s) (and/or any other component(s)) 104, a filling material 106, and a chip or a die (used interchangeably herewith) 110. One or more openings 107 (a, b, c, d) may be created on the bottom side 113 during a molding process of the housing 102, for example, such as, when the filling material 106 is being poured into a mold to create the structure 100. The filling materials 106 may be configured to be manufactured from an epoxy, plastic, and/or any other suitable non-conductive material.

The openings 107 may be configured to expose one or more metallized surfaces 108 (a, b, c, d) of the DCB component(s) 104. For example, the opening 107a may be configured to expose a metallized surface 108a. Exposing of the surfaces 108 using corresponding openings 107 may be configured to allow coupling of one or more lead terminals 112 (a, b, c, d).

The structure 100 may be configured to have any number of openings 107. The number of openings 107 may be selected in accordance with specific device designs, applications, requirements of other electronic components to which structure 100 may be coupled and/or any other uses. For example, as shown in FIG. 1d, the structure 100 may include three openings 107 (a, b, c) that may allow for connection of three terminals. Alternatively, or in addition to, as shown in FIG. 1e, the structure 100 may include four openings 107 (a, b, c, d) that may be configured for coupling of four terminals to the metallized surfaces 108.

As shown in FIGS. 1a-f, the openings 107 may be configured to have a rectangular shape on a bottom surface of the housing 102. In some exemplary implementations, the openings 107 have a trapezoidal cross-section, whereby their area distal from the metallized surfaces 108 is greater than their area proximal to the metallized surfaces 108. Such shape may be advantageous when coupling one or more terminals 112 to the metallized surfaces 108. In some implementations, the depth of the openings 107 may be controlled during the molding process (e.g., a specific depth may pre-selected prior to application of the filling material 106). Moreover, the depth of the openings 107 may be selected so as to be sufficient for exposing respective metallized surfaces 108 so that terminals 112 may be inserted into the openings 107 and coupled to the metallized surfaces 108. As can be understood, the openings 107 may be configured to have any desired shape, cross-section, depth, and/or any other dimensions.

In some implementations, the die 110 may be configured to be coupled to one or more DCB components 104. The coupling may be using any desired means, such as, for example, wire-bonding 114 (a, b) (as shown in FIGS. 1c and 1d), soldering, sintering, etc. Any number of couplings between the die 110 and the DCB components 104 may be made. As can be understood, the structure 100 might not be required to have a die (as for example is shown in FIG. 1a) and/or, alternatively, or in addition to, any other electronic component may be encapsulated into the housing 102 for connection to one or more DCB components 104.

FIG. 1f illustrates an exemplary process 150 for coupling one or more terminals 112 to the metallized surfaces 108 exposed by the openings 107 in the structure 100. One or more terminals 112 (a, b, c, d) (only terminals 112a and 112b are shown in FIG. 1f for ease of illustration) may be provided. The terminals 112 may be manufactured from any desired conductive materials, such as, for example, copper, copper alloy, metal, metal alloy, and/or any combination thereof. As shown in FIG. 1f, the terminals 112 may have a curved or bent shape, where one or more portions of the terminals 112 may be bent to conform to the cross-section of the opening 107 into which the terminal is being placed. Bent shape of the terminal 112 may assist in not only insertion of the terminal 112 into the opening 107 but also for coupling of the terminal 112 to the metallized surface 108.

For example, as shown in FIG. 1f, the terminal 112a may have a flat portion 152, a slanted portion 154, and a coupling portion 156. The slanted portion 154 may be positioned between the flat portion 152 and the coupling portion 156. As shown in FIG. 1f, the flat portion 152 and the coupling portion 156 may be substantially parallel to one another (as can be understood, it is not necessary for portions 152, 156 to be parallel to one another, e.g., they can be disposed at any desired angle with regard to one another). The slanted portion 154 may be configured to be disposed at an angle with respect to the portions 152 and 156. The angle of incline of the slanted portion 154 may be configured to substantially confirm to one of the vertical walls 158 of the opening 107a (as shown in FIG. 1f). This may enable ease of positioning of the terminal 112a into the opening 107a for coupling to the metallized surface 108a.

The coupling portion 156 may be configured to be coupled to the metallized surface 108a. To enable ease of positioning and coupling of the coupling portion 156 to the metallized surface 108a (and/or any other surface 108), the length and/or surface area of the coupling portion 156 may be smaller than at least one of the dimensions of the metallized surface 108a.

For positioning and coupling of the terminal 112a, as shown in FIG. 1f, the terminal 112a, provided at stage A, may be configured for insertion into the opening 107a of the housing 102, provided at stage B (the housing 102 and any of its encapsulated components along with openings 107 may have been previously pre-molded during the formation/molding process). At stage C, the terminal 112a may be inserted into the opening 107a until the coupling portion 156 comes into contact with the metallized surface 108a of the DCB component(s) 104. Once contact is achieved, the coupling portion 156 may be coupled to the metallized surface 108a. Any desired means (e.g., soldering, welding, etc.) may be used for the purposes of coupling of the coupling portion 156 and the metallized surface 108a. The other terminals 112 may be positioned and coupled into their respective openings 107 and metallized surfaces 108 in a similar fashion. As can be understood the structure 100 may have any number of openings 107, one or more of which may be accommodate positioning/coupling of one or more or no terminals 112.

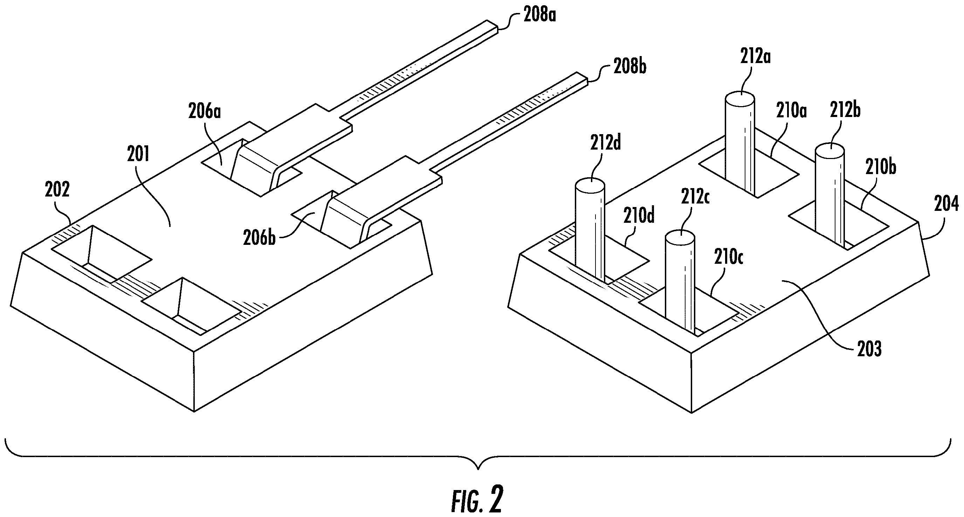

FIGS. 2-4 illustrate various ways of coupling of terminals to a packaging structure, such as, the structure 100 shown in FIG. 1a-f. FIG. 2 illustrates exemplary packaging structures 202 and 204, according to some implementations of the current subject matter. The structures 202 and 204 may be similar to the structure 100 shown in FIGS. 1a-f.

As shown in FIG. 2, the structure 202 may include four openings 206 that may be configured to expose metallized surfaces of one or more of its internal components (not shown in FIG. 2). The openings 206 may be positioned on a bottom surface of the structure 202, similar to the structure 100. Terminals 208 (a, b) may be configured for insertion (e.g., using "through-hole" technique) into the openings 206 (a, b), respectively. Once inserted into the openings 206 and coupled to the metallized surfaces (not shown in FIG. 2), the terminals 208 may be configured to extend from the openings 206 (e.g., portions 156 of the terminals (as shown in FIG. 1f) may be exposed outside of the device 202). Exposed portions of the terminals 208 may be used for coupling to a printed circuit board (PCB), and/or any other electronic components (not shown in FIG. 2). As shown in FIG. 2, only two terminals 208 are coupled into two openings 206 the device 202 and the other openings are not utilized.

Similarly, device 204 may include openings 210 (a, b, c, d) that may be used for positioning and/or coupling of terminals 212 (a, b, c, d), respectively. The openings 210 may (similar to device 202) be created in the bottom side 203 of the device 204. Utilizing the same "through-hole" technique, the terminals 212 may be coupled to the respective metallized surfaces of the device 204. As shown in FIG. 2, the terminals 212 may be in the form of cylindrical connectors, which, upon coupling to the respective metallized surfaces of the device 204, may be configured to protrude away from the surface 203. This may be helpful for positioning the device 204 away from other components and/or PCB.

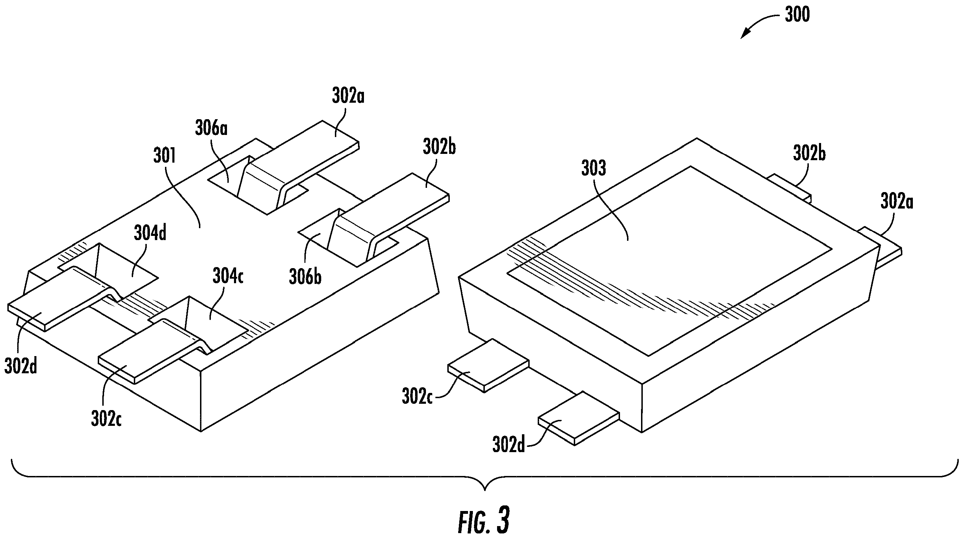

FIG. 3 illustrates another exemplary packaging structure 300, according to some implementations of the current subject matter. The structure 300 may be similar to the structure 100 shown in FIGS. 1a-f. As shown in FIG. 3, the structure 300 may have a top side 303 and a bottom side 301. The top side 303 may be positioned away from PCB and/or any other electronic components to which structure 300 may be coupled to using one or more of its terminals 302 (a, b, c, d). The terminals 302 may be configured for coupling to one or more metallized surfaces (not shown in FIG. 3) of the structure 300 by positioning the terminals 302 into respective openings 304 (a, b, c, d) and securing them to the metallized surfaces using any desired means (e.g., soldering, welding, etc.).

As shown in FIG. 3, the terminals 302 may be configured to have flat surfaces that may be used for coupling to PCB and/or any other electronic components. The arrangement of the terminals 302 in the structure 300 may be configured for surface mounting of the structure 300.

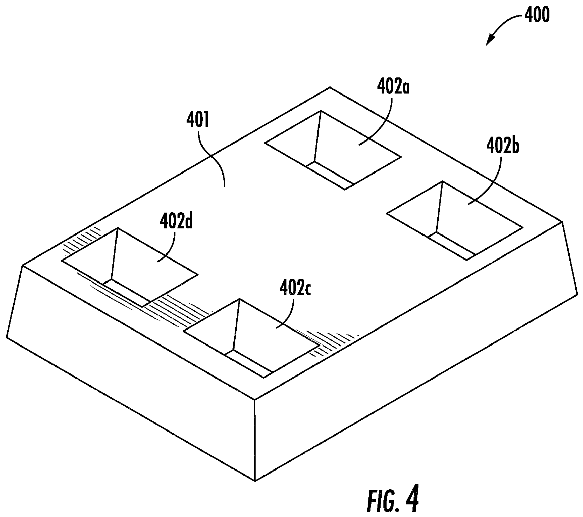

FIG. 4 illustrates yet another exemplary packaging structure 400, according to some implementations of the current subject matter. The structure 400 may be similar to the structure 100 shown in FIGS. 1a-f. As shown in FIG. 4, the structure 400 may have a bottom side 401 having one or more openings 402 (a, b, c, d). The openings 402 may be used for pressure and/or push fit of the structure 400 to a PCB and/or any other electronic components. The openings 402 may be so configured so as to allow insertion of existing connectors and/or terminals (not shown in FIG. 4) that may already be positioning on, for example, a PCB and/or other electronic components. To connect to such components, the device 400 may be configured to be aligned with and pressed onto such existing connectors/terminals, which may cause connection of the connectors/terminals to the metallized surfaces exposed by the openings 402.

The components and features of the devices described above may be implemented using any combination of discrete circuitry, application specific integrated circuits (ASICs), logic gates and/or single chip architectures. Further, the features of the devices may be implemented using microcontrollers, programmable logic arrays and/or microprocessors or any combination of the foregoing where suitably appropriate. It is noted that hardware, firmware and/or software elements may be collectively or individually referred to herein as "logic" or "circuit."

It will be appreciated that the exemplary devices shown in the block diagrams described above may represent one functionally descriptive example of many potential implementations. Accordingly, division, omission or inclusion of block functions depicted in the accompanying figures does not infer that the hardware components, circuits, software and/or elements for implementing these functions would necessarily be divided, omitted, or included in embodiments.

Some embodiments may be described using the expression "one embodiment" or "an embodiment" along with their derivatives. These terms mean that a particular feature, structure, or characteristic described in connection with the embodiment is included in at least one embodiment. The appearances of the phrase "in one embodiment" (or derivatives thereof) in various places in the specification are not necessarily all referring to the same embodiment. Moreover, unless otherwise noted the features described above are recognized to be usable together in any combination. Thus, any features discussed separately may be employed in combination with each other unless it is noted that the features are incompatible with each other.

It is emphasized that the abstract of the disclosure is provided to allow a reader to quickly ascertain the nature of the technical disclosure. It is submitted with the understanding that it will not be used to interpret or limit the scope or meaning of the claims. In addition, in the foregoing detailed description, it can be seen that various features are grouped together in a single embodiment for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the detailed description, with each claim standing on its own as a separate embodiment. In the appended claims, the terms "including" and "in which" are used as the plain-English equivalents of the respective terms "comprising" and "wherein," respectively. Moreover, the terms "first," "second," "third," and so forth, are used merely as labels, and are not intended to impose numerical requirements on their objects. Further, the use of "including," "comprising," or "having" and variations thereof herein is meant to encompass the items listed thereafter and equivalents thereof as well as additional items. Accordingly, the terms "including," "comprising," or "having" and variations thereof are open-ended expressions and can be used interchangeably herein.

For the sake of convenience and clarity, terms such as "top", "bottom", "upper", "lower", "vertical", "horizontal", "lateral", "transverse", "radial", "inner", "outer", "left", and "right" may be used herein to describe the relative placement and orientation of the features and components, each with respect to the geometry and orientation of other features and components appearing in the perspective, exploded perspective, and cross-sectional views provided herein. Said terminology is not intended to be limiting and includes the words specifically mentioned, derivatives therein, and words of similar import.

What has been described above includes examples of the disclosed architecture. It is, of course, not possible to describe every conceivable combination of components and/or methodologies, but one of ordinary skill in the art may recognize that many further combinations and permutations are possible. Accordingly, the novel architecture is intended to embrace all such alterations, modifications and variations that fall within the spirit and scope of the appended claims.

The foregoing description of example embodiments has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto. Future filed applications claiming priority to this application may claim the disclosed subject matter in a different manner and may generally include any set of one or more limitations as variously disclosed or otherwise demonstrated herein.

All directional references (e.g., proximal, distal, upper, lower, upward, downward, left, right, lateral, longitudinal, front, back, top, bottom, above, below, vertical, horizontal, radial, axial, clockwise, and counterclockwise) are just used for identification purposes to aid the reader's understanding of the present disclosure, and do not create limitations, particularly as to the position, orientation, or use of this disclosure. Connection references (e.g., attached, coupled, connected, and joined) are to be construed broadly and may include intermediate members between a collection of elements and relative movement between elements unless otherwise indicated. As such, connection references do not necessarily infer that two elements are directly connected and in fixed relation to each other.

Further, identification references (e.g., primary, secondary, first, second, third, fourth, etc.) are not intended to connote importance or priority but are used to distinguish one feature from another. The drawings are for purposes of illustration only and the dimensions, positions, order and relative sizes reflected in the drawings attached hereto may vary.

The present disclosure is not to be limited in scope by the specific implementations described herein. Indeed, other various implementations of and modifications to the present disclosure, in addition to those described herein, will be apparent to those of ordinary skill in the art from the foregoing description and accompanying drawings. Thus, such other implementations and modifications are intended to fall within the scope of the present disclosure. Furthermore, the present disclosure has been described herein in the context of a particular implementation in a particular environment for a particular purpose. Those of ordinary skill in the art will recognize the usefulness is not limited thereto and the present disclosure may be beneficially implemented in any number of environments for any number of purposes. Thus, the claims set forth below are to be construed in view of the full breadth and spirit of the present disclosure as described herein.

## Claims

1. An apparatus, comprising:
a housing having a top side and a bottom side, the housing encapsulating one or more electronic components; and
one or more openings disposed in the bottom side of the housing, the one or more openings are configured for exposing one or more metallized surfaces of the one or more electronic components;
the one or more metallized surfaces are configured for coupling to one or more lead terminals.

2. The apparatus according to claim 1, wherein the one or more electronic components include at least one of the following: direct copper bonded (DCB) substrate components, active metal brazed (AMB) substrate components, insulated metal substrate (IMS) components, and any combination thereof.

3. The apparatus according to claim 1 or 2, wherein the housing is configured encapsulate one or more semiconductor chips coupled to the one or more electronic components.

4. The apparatus according to claim 3, wherein the one or more semiconductor chips and the one or more electronic components are configured to be coupled using at least one of the following: wire-bonding, one or more electrically-conductive clips, silver-sintering, soldering, and any combination thereof.

5. The apparatus according to any of the preceding claims, wherein the one or more lead terminals are configured to be coupled to the one or more metallized surfaces of the one or more electronic components by
inserting the one or more lead terminals through the one or more openings;
contacting the inserted one or more lead terminals with the one or more metallized surfaces; and
coupling the contacting one or more lead terminals and the one or more metallized surfaces.

6. The apparatus according to any of the preceding claims, wherein the one or more lead terminals are permanently coupled to the one or more metallized surfaces, or wherein the one or more lead terminals are temporarily coupled to the one or more metallized surfaces.

7. The apparatus according to claim 6, wherein, when the one or more lead terminals are permanently coupled to the one or more metallized surfaces, the apparatus is configured for at least one of through-hole mounting and surface mounting to at least another one or more electronic components using the one or more permanently coupled lead terminals.

8. The apparatus according to claim 6, wherein when the one or more lead terminals are temporarily coupled to the one or more metallized surfaces, the apparatus is configured for push-fit mounting to at least another one or more electronic components using the one or more temporarily coupled lead terminals.

9. The apparatus according to any of the preceding claims, wherein the one or more lead terminals are manufactured using at least one of the following: a copper, a copper alloy, a metal, a metal alloy, and any combination thereof.

10. The apparatus according to any of the preceding claims, wherein the housing is manufactured from at least one of the following: an epoxy compound, a plastic, and any combination thereof.

11. The apparatus according to any of the preceding claims being a packaging structure, further comprising:
one or more lead terminals, wherein the one or more metallized surfaces are configured for coupling to the one or more lead terminals;
wherein the one or more lead terminals are configured to be coupled to the one or more metallized surfaces of the one or more electronic components by
inserting the one or more lead terminals through the one or more openings;
contacting the inserted one or more lead terminals with the one or more metallized surfaces; and
coupling the contacting one or more lead terminals and the one or more metallized surfaces.

12. The apparatus according to claim 11, wherein the one or more semiconductor chips and the one or more electronic components are configured to be coupled using at least one of the following: wire-bonding, one or more electrically-conductive clips, silver-sintering, soldering, and any combination thereof.

13. Use of an apparatus according to any of the preceding claims for creating variety of lead connection.

14. Use of an apparatus according to any of the preceding claims 1-12 for combatting voltage creepage due to distance between the lead terminals.
